# EUROPEAN PATENT APPLICATION

(11) **EP 3 409 651 A1**
(43) Date of publication of application: **05.12.2018**
(21) Application number: 17382315.4
(22) Date of filing: 31.05.2017
(51) Int. Cl.: C04B 35/462, C04B 35/472, C04B 35/626, C04B 35/64, H01L 41/43, H01L 41/187

(54) **A HIGH TEMPERATURE AND POWER PIEZOELECTRIC, BISCO3-PBTIO3 BASED CERAMIC MATERIAL MICROSTRUCTURALLY ENGINEERED FOR ENHANCED MECHANICAL PERFORMANCE, A PROCEDURE FOR OBTAINING SAID CERAMIC MATERIAL AND ITS USE AS PART OF AN ULTRASOUND GENERATION DEVICE OR ULTRASONIC ACTUATION DEVICE**

(71) Applicant: Consejo Superior de Investigaciones Científicas (CSIC), 28006 Madrid (ES)
(72) Inventor: ALGUERÓ GIMÉNEZ, Miguel, 28049 MADRID (ES); AMORÍN GONZÁLEZ, Harvey, 28049 MADRID (ES); CASTRO LOZANO, Alicia, 28049 MADRID (ES)
(74) Representative: Pons

(57) **Abstract**

A high temperature and power piezoelectric, BiScO₃-PbTiO₃ based ceramic material microstructurally engineered for enhanced mechanical performance, a procedure for obtaining said ceramic material and its use as part of an ultrasound generation device or ultrasonic actuation device.

The invention relates to a high temperature piezoelectric BiScO₃-PbTiO₃ ceramic material of formula Bi_{0.36}Pb_{0.64}Sc_{0.36-x}MnₓTi_{0.64}O₃, wherein x ranges from 0.02 to 0.05, which includes a point defect engineering for strongly reduced dielectric and mechanical losses, and also has an optimized microstructure for enhanced fracture strength. Furthermore, the invention refers to a procedure for obtaining said ceramic material by hot pressing of nanocrystalline powders derived by mechanosynthesis from a stoichiometric mixture of precursors and its use as part of an ultrasound generation device.

## Description

The invention relates to a high temperature piezoelectric BiScO₃-PbTiO₃ ceramic material of formula Bi_{0.36}Pb_{0.64}Sc_{0.36-x}MnₓTi_{0.64}O₃, wherein x ranges from 0.02 to 0.05, which includes a point defect engineering for strongly reduced dielectric and mechanical losses, and also has an optimized homogeneous and grained microstructure for enhanced fracture strength. Furthermore, the invention refers to the procedure for obtaining said ceramic material by hot pressing of nanocrystalline powders derived by mechanosynthesis from a stoichiometric mixture of precursors and its use as part of an ultrasound generation device.

### STATE OF ART

BiScO₃-PbTiO₃ is the most promising system among general formula BiMO₃-PbTiO₃, wherein M is a trivalent cation in octahedral coordination, perovskite solid solutions with enhanced electromechanical response at ferroelectric morphotropic phase boundaries (MPB), and high Curie temperature. This material is being extensively investigated as an alternative to state of the art Pb(Zr,Ti)O₃ (PZT) for expanding the operation temperature of high sensitivity piezoelectric ceramics beyond 200ºC up to 400ºC.

Specifically, the binary system (1-x)BiScO₃-xPbTiO₃ presents a MPB between ferroelectric polymorphic phases of rhombohedral *R3m* and tetragonal *P*4*mm* symmetry at x∼0.64, composition for which the Curie temperature *T_{C}* is ≈ 450ºC, while piezoelectric coefficients *d₃₃* of -450 pC N⁻¹ are typically achieved after poling. This *T_{C}* is 100ºC above that of Pb(Zr,Ti)O₃, likewise *d₃₃* that also significantly exceeds the figure of ≈ 245 pC N⁻¹ for ceramics of the latter material at its own MPB. Moreover, the charge piezoelectric coefficient is comparable to those of available commercial high sensitivity piezoelectric ceramics of chemically engineered PZT.

However, and in spite of the theoretically expanded operation temperature range enabled by the high Curie temperature, BiScO₃-PbTiO₃ cannot be directly used in most applications. This is the case of ultrasound generation and ultrasonic motors/actuators that involve high power operation, for the material dielectric and mechanical losses cause heating during driving. CSIC has recently developed a high temperature piezoelectric BiScO₃-PbTiO₃ ceramic material chemically engineered for high power operation, suitable for these applications (P201531907 or PCT/EP2016/082424).

A common issue to all piezoelectric ceramics, to which BiScO₃-PbTiO₃ is not oblivious, is their low fracture toughness and thus, poor strength. This not only limits strain and stress operation levels, but often also makes machining difficult, even preventing the fabrication of ceramic elements with required nonconventional shapes and/or features.

A possible solution is grained ceramic microstructure refinement down to the submicron range, which is a well known procedure to enhance mechanical performance. However, and in the case of grained ferroelectric ceramics, this is usually accompanied with a distinctive degradation of piezoelectric coefficients (see for instance Chapter 16. The effect of ceramic nanostructuring in high sensitivity piezoelectrics, by H. Amorín et al, in Nanoscale Ferroelectrics and Multiferroics, M. Algueró, J.M. Gregg and L. Mitoseriu eds., John Wiley & Sons Ltd. 2016, ISBN: 978-1-118-93575-0).

Therefore, and for the reasons stated above, it is needed to develop new piezoelectric ceramics that show good down-scaling behaviour of properties with grain size, capable to provide enhanced mechanical performance while maintaining full functionality.

### DESCRIPTION OF THE INVENTION

The present invention discloses a piezoelectric ceramic material of formula Bi_{0.36}Pb_{0.64}Sc_{0.36-x}MnₓTi_{0.64}O₃, wherein x ranges from 0.02 to 0.05, which exhibits an enhanced electrochemical response at a perovskite morphotropic phase boundary between polymorphs of rhombohedral *R3m* and tetragonal *P*4*mm* symmetries, high Curie temperature, and a point defect engineering for strongly reduced dielectric and mechanical losses.

Furthermore, the high temperature, high sensitivity and low loss piezoelectric ceramic material of the present invention has a fully dense and homogeneous microstructure, particularly it has a fine or ultrafine grained microstructure with an average grain size that can be tailored from 3 down to 0.25 µm.

Specifically, ceramic materials with x = 0.02, densification above 99 % and a grain size of ∼ 0.85 µm have a Curie temperature of ≈ 435 ºC, and a *d₃₃* coefficient of ≈ 240 pC/N that can be enhanced up to ≈ 275 pC/N by microstructure coarsening up to the micron range, always maintaining dielectric and mechanical losses below 0.03 and 0.01, respectively.

Moreover, the present invention discloses a process for obtaining said ceramic material that refers to its preparation by hot pressing of nanocrystalline powders derived by mechanosynthesis in a high energy planetary mill.

The hot pressing procedure based on these highly reactive powders allows grained ceramics approaching full densification to be obtained with enhanced mechanical performance, which maintain the functionality of coarse grained materials obtained by conventional sintering of the same powders, particularly allows the preparation of ultrafine grained ceramics. Besides, Bi₂O₃ and PbO volatilization during hot pressing is not an issue because of low processing temperatures, so that stoichiometric mixtures of the precursors (Bi₂O₃, Sc₂O₃, PbO, TiO₂ and Mn₂O₃) can be used. This is very advantageous for an accurate control of composition and phase coexistence while point defects are engineered, which cannot be reproducibly achieved by conventional ceramic technologies such as solid state synthesis by heating of precursors.

A first aspect of the present invention relates to a piezoelectric ceramic material
- of general formula Bi_{0.36}Pb_{0.64}Sc_{0.36-x}MnₓTi_{0.64}O₃, wherein x ranges from 0.02 to 0.05,
- and perovskite single phase placed at a morphotropic phase boundary between polymorphs of rhombohedral *R3m* and tetragonal *P*4*mm* symmetries,
characterized in that it has a fully dense microstructure with average grain size of between 3 µm and 0.25 µm.

The piezoelectric ceramic material of the present invention has perovskite single phase placed at a morphotropic phase boundary between polymorphs of rhombohedral *R3m* and tetragonal *P*4*mm* symmetries that is the responsible for the high piezoelectric response and, moreover, it includes an engineered point defect for strongly reduced dielectric and mechanical losses that enables high power operation.

The term "engineered point defect" refers to a point defect that is introduced at or around a single lattice point of the perovskite, specifically by the controlled substitution of Mn³⁺ for Sc³⁺ in the B-site (octahedral coordination) of the ABO₃ perovskite, its partial reduction to Mn²⁺ in the presence of oxygen vacancies, and the association of the two chemical species to form Mn²⁺-Oxygen vacancy dipolar complexes that effectively decrease the ferroelectric domain wall mobility, and thus, result in the reduced dielectric and mechanical losses. This controlled substitution is achieved while the material is maintained at the morphotropic phase boundary between polymorphs of rhombohedral *R3m* and tetragonal *P*4*mm* symmetries, known to be required for high piezoelectric response.

Additionally, microstructure is refined at the same time point defects are introduced, so that an optimized fully dense this means densification above 99 %, fine or ultrafine grained microstructure is obtained by hot pressing for optimal mechanical performance.

The fine or ultrafine grained microstructure of the present invention is characterized by an average grain size of between 3 µm and 0.25 µm.

The term "fine grained microstructure" is used herein to define an average grain size of between 3 µm and 1 µm, while the term "ultrafine grained microstructure" is used herein to define an average grain size of less than 1 µm.

In a preferred embodiment, the fully dense piezoelectric ceramic material of the present invention has an ultrafine grained microstructure with average grain size of less than 1 µm, more preferably an average grain size of between 1 and 0.25 µm.

In another preferred embodiment of the present invention, the piezoelectric ceramic material mentioned above has the formula Bi_{0.36}Pb_{0.64}Sc_{0.36-x}MnₓTi_{0.64}O₃, wherein x ranges from 0.02 and 0.03.
A second aspect of the present invention relates to a procedure for obtaining the piezoelectric ceramic material mentioned above, characterized in that it comprises the following steps:
a) preparation of a nanocrystalline powder of formula Bi_{0.36}Pb_{0.64}Sc_{0.36-x}MnₓTi_{0.64}O₃, by mechanosynthesis from a stoichiometric mixture of Bi₂O₃, Sc₂O₃, PbO, TiO₂ and Mn₂O₃, wherein x ranges from 0.02 to 0.05; and
b) hot pressing of the nanocrystalline powder obtained in step (a)
   - at a temperature range of between 1000 ºC and 700 ºC for soaking times between 5 h and 30 min
   - or a pressure range of between 30 MPa and 90 MPa, for soaking times between 5 h and 30 min.

In a preferred embodiment of the procedure of the invention, the activation of step (a) is performed, in a high energy planetary mill, at 300 rpm for times between 15 h and 20 h.

The relationship between the grain size and temperature or the time can be simplified by considering that a decrease of the grain size is obtained at low temperatures and short soaking times, while the relationship between the grain size and pressure is the opposite; a decrease of the grain size is obtained at high pressures.

Therefore, for obtaining a fully dense microstructure with average grain size of between 3 µm and 0.25 µm, there are two possible ways of performing step (b) of hot pressing of the nanocrystalline powder obtained in step (a):
- fixing a pressure and varying the temperature in a range of between 1000 ºC and 700 ºC for soaking times between 5 h and 30 min
- or fixing a temperature and varying the pressure range of between 30 MPa and 90 MPa, for soaking times between 5 h and 30 min.

In a preferred embodiment of the present procedure, particularly for obtaining an ultrafine-grained microstructure (an average grain size of less than 1 µm), the hot pressing of step (b) is performed
- fixing a pressure and varying the temperature in a range of between 900 ºC and 700 ºC for soaking times between 2 h and 30 min,
- or fixing a temperature and varying the pressure in a range of between 60 MPa and 90 MPa for soaking times between 2 h and 30 min.

A third aspect of the invention refers to the use of the piezoelectric ceramic material mentioned above, as part, so to say active element in ultrasound generation devices or ultrasonic motors/actuators.

Unless otherwise defined, all technical and scientific terms used herein have the same meaning as commonly understood by one of ordinary skilled in the art to which this invention belongs. Methods and materials similar or equivalent to those described herein can be used in the practice of the present invention. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention. The following examples and drawings are provided by way of illustration and are not intended to be limiting of the present invention.

### BRIEF DESCRIPTION OF THE DRAWINGS

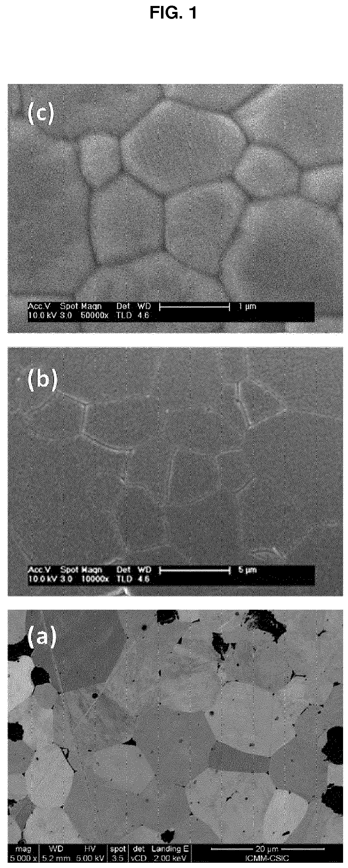

FIG. 1 Scanning electron microscopy (SEM) images of Bi_{0.36}Pb_{0.64}Sc_{0.36-x}MnₓTi_{0.64}O₃ ceramic samples with x = 0.02, processed by either (a) conventional sintering at 1125 ºC for exaggerated grain growth, or hot pressing at 60 MPa and (b) 1000 ºC or (c) 900 ºC for fully dense and fine or ultrafine grained microstructure.

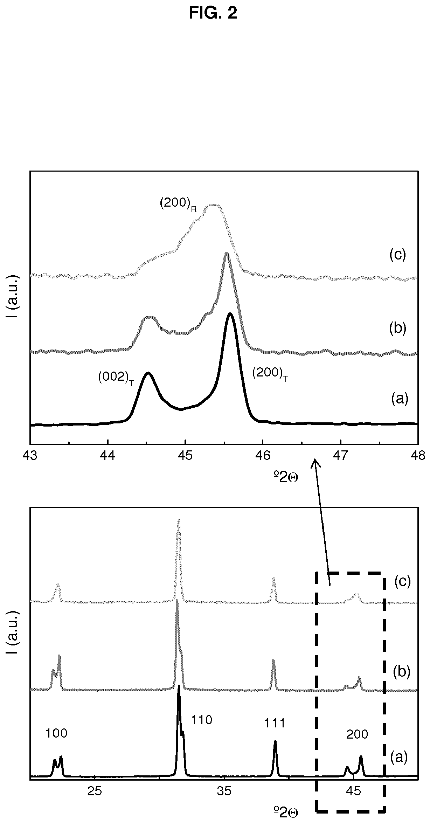

FIG. 2 XRD patterns for Bi_{0.36}Pb_{0.64}Sc_{0.36-x}MnₓTi_{0.64}O₃ ceramic samples with x = 0.02, processed by either (a) conventional sintering at 1125 ºC, or hot pressing at 60 MPa and (b) 1000 ºC or (c) 900 ºC, showing the absence of secondary phases other than perovskite in all cases. The °2θ range across the perovskite parent cubic phase 200 diffraction peak is expanded to show polymorphic phase coexistence and thus, location of all materials with decreasing grain size down to the submicron range at the morphotropic phase boundary.

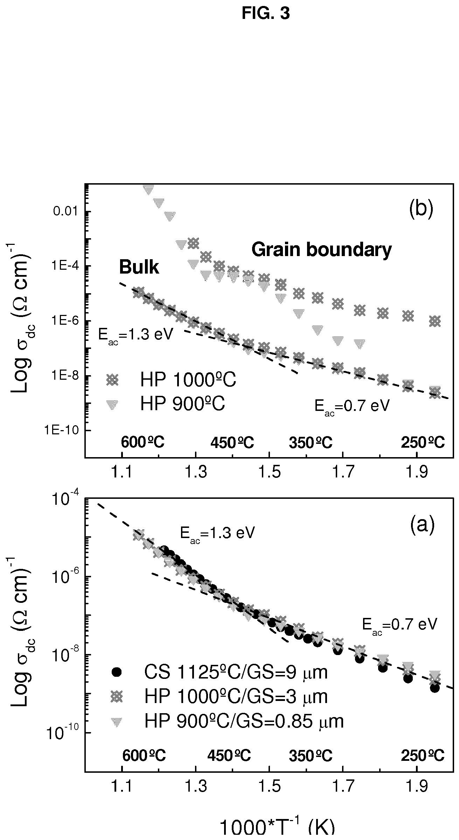

FIG. 3 Arrhenius plots for (a) the total dc conductivity of Bi_{0.36}Pb_{0.64}Sc_{0.36-x}MnₓTi_{0.64}O₃ ceramic samples with x = 0.02, processed by either conventional sintering (CS) or hot pressing (HP), along with (b) its bulk and grain boundary components demonstrating the correct incorporation of the point defects for all materials with decreasing grain size down to the submicron range (by the appearance of the low temperature electronic conduction mechanism with E_{ac} ≈ 0.7 eV).

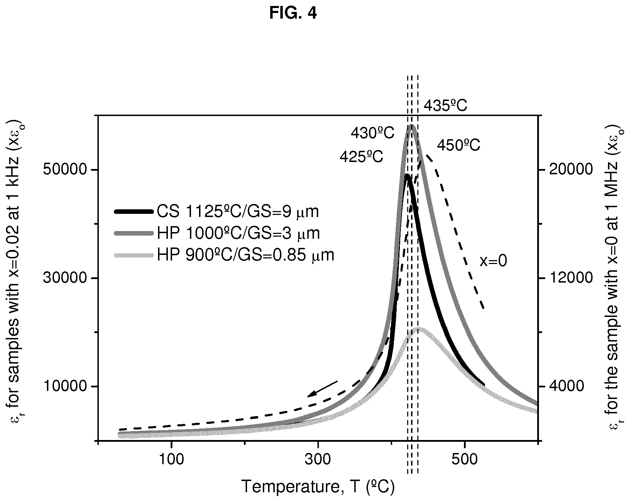

FIG. 4 Temperature dependence of the relative permittivity for Bi_{0.36}Pb_{0.64}Sc_{0.36-x}MnₓTi_{0.64}O₃ ceramic samples with x = 0.02, processed by either conventional sintering (CS) or hot pressing (HP), showing the position of the ferroelectric transition (that determines the maximum operation temperature). Permittivity for a Bi_{0.36}Pb_{0.64}Sc_{0.36}Ti_{0.64}O₃ fine grained ceramic is included (dashed line: CS 1100ºC/GS = 2.4 µm) in order to illustrate the shift of the critical temperature after point defect introduction for all materials with decreasing grain size (GS) down to the submicron range.

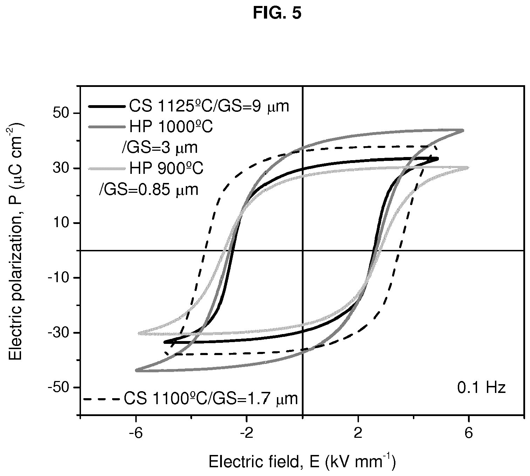

FIG. 5 Ferroelectric hysteresis loops for Bi_{0.36}Pb_{0.64}Sc_{0.36-x}MnₓTi_{0.64}O₃ ceramic samples with x = 0.02, processed by either conventional sintering (CS) or hot pressing (HP).

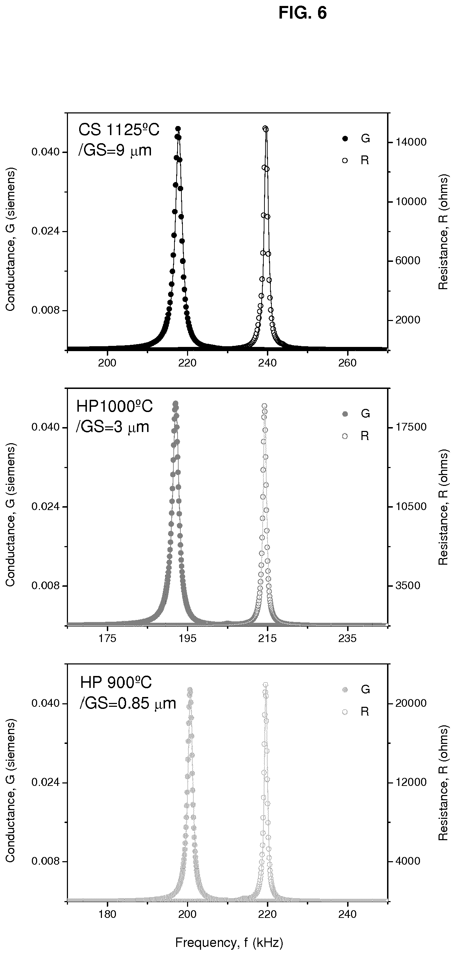

FIG. 6 Piezoelectric radial resonances for Bi_{0.36}Pb_{0.64}Sc_{0.36-x}MnₓTi_{0.64}O₃ ceramic samples with x = 0.02, processed by either conventional sintering (CS) or hot pressing (HP). Note the high mechanical quality factor (and thus low losses) for all coarse and ultrafine grained materials. Average grain size (GS) is indicated.

### EXAMPLES

### Preparation of fine and ultrafine grained Bi_{0.36}Pb_{0.64}Sc_{0.36-x}MnₓTi_{0.64}O₃ piezoelectric ceramic samples with x = 0.02.

Perovskite single phase nanocrystalline powders of Bi_{0.36}Pb_{0.64}Sc_{0.36-x}MnₓTi_{0.64}O₃ with x = 0.02 were synthesized by mechanochemical activation of stoichiometric mixtures of analytical grade Bi₂O₃ (Aldrich, 99.9 % pure), Sc₂O₃ (Aldrich, 99.9 % pure), PbO (Merck, 99 % pure), TiO₂ (anatase, Cerac, 99 % pure) and Mn₂O₃ (Aldrich, 99 % pure) with a Pulverisette 6 model Fritsch planetary mill. About 10 g of the mixture of the precursor oxides was initially homogenized by hand in an agate mortar, and placed in a tungsten carbide (WC) jar of 250 ml with seven, 2 cm diameter, 63 g mass each, WC balls for activation at 300 r.p.m. for 20 h.

These conditions provide perovskite single phase fully crystalline powders with nanometer-scale chemical homogeneity.

About 1 g of nanocrystalline powder was uniaxially pressed into 12 mm diameter pellets, which were, afterwards, hot pressed at temperatures of 1000 ºC and 900 ºC and under a pressure of 60 MPa for fine and ultrafine grained microstructures, respectively. Hot pressing was applied once the targeted temperature was reached, and released when cooling started. A soaking time of 1 h and heating/cooling rates of ± 3 ºC min⁻¹ were selected.

Note that PbO or Bi₂O₃ losses did not take place during hot pressing at these low temperatures, so that the use of stoichiometric mixtures of precursors was allowed. This is essential for an accurate composition and phase coexistence control, which is the key to high sensitivity. Herein, microstructure is engineered down to the submicron range while maintaining full control of the perovskite structural characteristics and the introduced point defects.

Densification values above 99 %, and homogenous fine or ultrafine-grained microstructures were obtained with decreasing processing temperature or/and increasing pressure.

Additionally, and aiming to provide comparative data, a coarse grained material was also processed by air sintering at 1125 ºC. A different powder batch that had been activated for only 15 h was used in this case to trigger exaggerated grain growth. Indeed, an average grain size of 9 µm was so obtained. These samples are hereinafter referred to as *conventional sintering (CS) samples.*

### Characterization of the piezoelectric ceramic materials

Samples for phase and microstructural characterizations were prepared by thinning of ceramics to remove one surface (∼ 100 µm), followed by polishing to a mirror finish. A final thermal treatment at 600 ºC for 2 h with ± 0.5 ºC min⁻¹ was carried out to remove the damage introduced, and to restore the equilibrium polymorphic phase coexistence and domain configurations, which are modified by the shear stresses involved in polishing.

Phases and perovskite phase characteristics were controlled by X-ray diffraction (XRD) with a Bruker AXS D8 Advance diffractometer and CuK_{α} radiation (λ = 1.5418 Å). Patterns were recorded between 20 º and 50 º (2θ) with 0.05 º (2θ) step and 0.3 s counting time.

Microstructure was studied with a Philips XL30 S-FEG field emission gun scanning electron microscope on sample pieces that had been quenched from 850 ºC for revealing grain boundaries.

Ceramic capacitor for electrical and electromechanical characterizations were prepared by thinning discs down 0.5 mm, painting of Ag electrodes on the major faces, and their sintering at 700 ºC.

Electrical characterization started by evaluating the total dc conductivity, along with its bulk and grain boundary components by impedance spectroscopy analysis. Data were recorded in static conditions, from 250 ºC to 600 ºC, at 20 ºC intervals, in the 20 Hz - 1 MHz range with an Agilent E4980A precision LCR meter. The Z-view2 commercial software was used for the analysis.

Dielectric permittivity and ferroelectric hysteresis loops were characterized in a second stage. Dependences of the dielectric permittivity and losses on temperature were measured between room temperature (RT) and 600 ºC with the Agilent E4980A precision LCR meter. Measurements were dynamically carried out during a heating/cooling cycle with ± 1.5 ºC min⁻¹ rate at several frequencies between 100 Hz and 1 MHz. Room temperature ferroelectric hysteresis loops were recorded under voltage sine waves of increasing amplitude up to 10 kV with a 0.1 Hz frequency, obtained by the combination of a synthesizer/function generator (HP 3325B) and a high voltage amplifier (TREK model 10/40), while charge was measured with a homebuilt charge to voltage converter and software for loop acquisition and analysis.

Finally, the ceramic discs were poled for electromechanical characterization. A field of 5 kV mm⁻¹ was applied at 100 ºC for 15 min, and maintained during cooling down to 40 ºC. The longitudinal piezoelectric coefficient *d₃₃* was then measured 24 h after the poling step with a Berlincourt type meter. Also, the transverse piezoelectric coefficient was obtained by complex analysis of piezoelectric radial resonances of the discs by the automatic iterative method described in C. Alemany et al J Phys D: Appl Phys 1995; 28:945. This procedure also provides the *s₁₁^{E}* and *s₁₂^{E}* compliances and *ε₃₃^{σ}* permittivity of the poled material all in complex form and thus, all mechanical, electrical and electromechanical losses.

It is worth remarking the enhanced dielectric strength of the hot pressed materials. Indeed, these fine and ultrafine grained ceramics withstood fields as high as 6 kV mm⁻¹ without undergoing breakdown, which are well above typical ones for BiScO₃-PbTiO₃ coarse grained materials. There is direct correlation between dielectric and mechanical strength, which is also indicated by the remarkably good performance of the ceramic samples during machining. Scanning electron microscopy (SEM) images of the hot pressed ceramics are shown in Figure 1. A homogenous, fine grained microstructure with average grain size of ∼ 3 µm was obtained when processing was carried out at 1000 ºC, which was decreased down to ∼ 0.85 µm when temperature was lowered down to 900 ºC. A SEM image of the coarse grained material is also included as reference for the rest of figures.

XRD patterns for the hot pressed ceramic materials are shown in Figure 2, along with that for the coarse grained material. No secondary phases in addition to the perovskite one are found for any ceramic, suggesting the targeted incorporation of the point defects into the structure for all materials including that with ultrafine microstructure.

Patterns across the perovskite parent cubic phase 200 diffraction peak are expanded in this Figure 2. Note polymorphic phase coexistence and thus, location of all materials with decreasing grain size down to the submicron range at the morphotropic phase boundary. Actually, a distinctive increase in the percentage of rhombohedral phase was found for the material with the smallest grain size, yet still in coexistence with a significant amount of tetragonal phase. Size driven polymorphic phase transitions have already been described in other perovskite oxide solid solutions.

The effective incorporation of point defects into the perovskite for all materials including that with ultrafine microstructure, avoiding the segregation of manganese oxides at the grain boundaries, was clearly indicated by conductivity. The Arrhenius plots for the total dc conductivity of the hot pressed materials are shown in Figure 3, along with that for the coarse grained ceramic. All materials show a common high temperature regime characterized by activation energy of ∼ 1.3 eV. This value is typical of the electromigration of mobile doubly ionized oxygen vacancies V_{O}" and thus, ionic conductivity is assumed to dominate the electrical response above 400 ºC. A decrease of conductivity takes place in this regime after Mn substitution, which has been associated with the partial reduction of the Mn³⁺ to Mn²⁺, and its association with oxygen vacancies to form dipolar complexes that effectively pin the ionic charge carriers.

The temperature dependence of conductivity shows a distinctive change of slope at ∼ 400 ºC, so that a low temperature regime characterized by activation energy of ∼ 0.7 eV exists. This value is rather typical of electronic conduction than of ionic one, and it has been associated with hole conduction within the valence band, specifically with electron hopping between Mn²⁺ and Mn³⁺ at the B-site. Its observation in the hot pressed samples indicates the Mn incorporation into the perovskite structure in these samples with fine or ultrafine microstructure.

Impedance spectroscopy analysis was used to isolate bulk (or grain) and grain boundary contributions to the total electrical response, and to confirm that Mn effects on conductivity were truly bulk effects, and not grain boundary ones. Data were initially analyzed using the electric modulus formalism, which allowed two Debye-like relaxation processes to be readily identified for all materials with decreasing grain size down to the submicron range. This indicates the presence of two electroactive regions that are associated with the bulk (low frequency process) and grain boundary (high frequency process). The contributions of the two regions were separated by using an equivalent electric circuit to model the experimental data. A series connection of two parallel (RQC) and (RQ) elements for the bulk and grain boundary components was used respectively. Results are also given in Figure 3. Note that the low temperature electronic process that has been associated with hopping between Mn²⁺-Mn³⁺ species at the B-site of the perovskite is observed in the bulk component for all materials. This definitively confirms the correct incorporation of Mn into the perovskite, also in the case of the hot pressed ceramics.

Mn incorporation into the bulk perovskite is also responsible of the decrease of the ferroelectric transition temperature, evaluated from the position of the dielectric anomaly. This is illustrated in Figure 4, where the temperature dependence of permittivity is shown for the hot pressed materials, along with that for the coarse grained ceramic. The dielectric anomaly associated with the transition is observed at a temperature of 430 ºC and 435 ºC for the materials processed at 1000 ºC and 900 ºC, respectively, and at 425 ºC for the coarse grained material. There seems to be a slight shift of the transition temperature towards high temperatures with the decrease of grain size. This might indicate partial Mn incorporation at low processing temperatures, yet the highest temperature of 435 ºC is still far from the value of 450 ºC, characteristic of the unmodified BiScO₃-PbTiO₃ composition. Permittivity for one such material is included for comparison. Note that curves at 1 kHz are given for the materials with x = 0.02, while permittivity at 1 MHz is shown for x = 0. This is due to the existence of a high temperature dielectric relaxation for the former case that overlaps with the transition anomaly at high frequency, and of high temperature conductivity in the latter case that masks the anomaly at low frequency. Chosen curves are reckoned to be the most suitable for identifying the transition in each case.

The room temperature dielectric permittivity (*ε₃₃^{σ}* Unpoled) and losses (*Tan δ* Unpoled) at 1 kHz, are given in Table I, along with the Curie temperature (*T_{C}*). Note the very low dielectric losses for all materials.

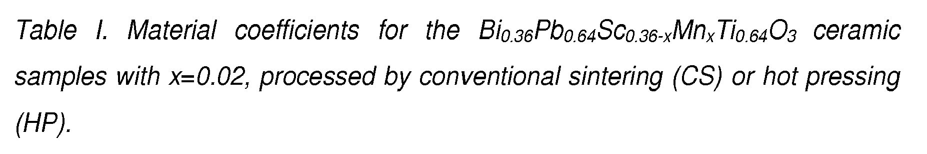

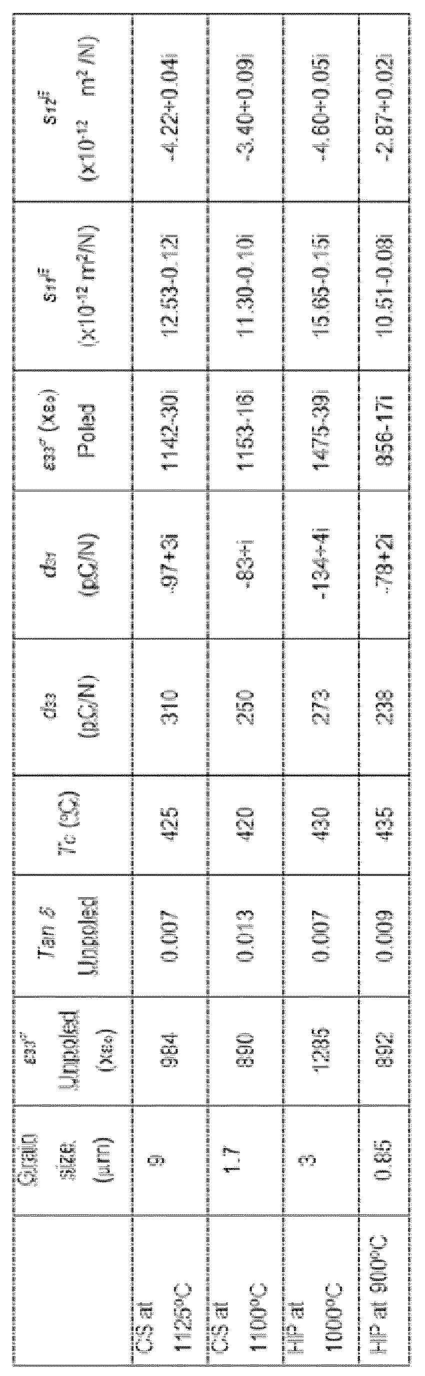

Ferroelectric hysteresis loops for the hot pressed materials are shown in Figure 5, along with that for the coarse grained material. An unexpectedly low remnant polarization was found for the coarse grained ceramic as compared with that of the material hot pressed at 1000ºC, in spite of its much larger grain size. This is most probably a consequence of the presence, or generation during electrical cycling, of microcracks, and illustrates the poor mechanical performance of these ceramics with grain size close to 10 µm. Indeed, remnant polarization values increased when conventional sintering was tailored to decrease ceramic grain size, as shown in the Figure for a material with grain size of 1.7 µm (material parameters for this fine grained ceramic are also given in the Table as "CS at 1100 ºC"). It is remarkable that BiScO₃-PbTiO₃ materials present hardly degradation of ferroelectric properties with the decrease of grain size down to the submicron range.

Charge longitudinal coefficient *d₃₃* values after poling are also given in Table I. There is a slight decrease of coefficients with grain size down to the submicron range, yet it stands out that ceramics with an average grain size of 0.85 µm still have a d₃₃ of 238 pC/N.

Piezoelectric radial resonances for materials with decreasing grain size down to the submicron range are shown in Figure 6. Note the small width of all the resonances, indicating high mechanical quality factors *Qₛ* (defined as fₛ/Δfₛ, where fₛ is the position of the conductance maximum and Δfₛ is its full width at half maximum) and *Qₚ* (defined as fₚ/Δfₚ, where fₚ is the position of the resistance maximum and Δfₚ is its full width at half maximum) of 100-140 and 200-240, respectively.

Complex material coefficients obtained from the analysis of these resonances are given in Table I. Trends of the *d₃₁* piezoelectric coefficient were consistent with those of *d₃₃*, and low dielectric and mechanical losses were found for all materials with decreasing grain size down to the submicron range, with loss values of 0.020 and 0.008, respectively, for the ultrafine grained material with average grain size of 0.85 µm, which also has a *d₃₁* of 78 pC/N.

## Claims

1. A piezoelectric ceramic material
- of general formula Bi_{0.36}Pb_{0.64}Sc_{0.36-x}MnₓTi_{0.64}O₃, wherein x ranges from x=0.02 to 0.05,
- and perovskite single phase placed at a morphotropic phase boundary between polymorphs of rhombohedral *R3m* and tetragonal *P*4*mm* symmetries,
**characterized in that** it has a fully dense microstructure with average grain size of between 3 µm and 0.25 µm.

2. The ceramic material according to claim 1, **characterized in that** it has an ultrafine grained microstructure with an average grain size of less than 1 µm.

3. The ceramic material according to any of claims 1 or 2, **characterized in that** it has a an ultrafine grained microstructure with an average grain size of between 1 µm and 0.25 µm.

4. The ceramic material according to any of claims 1 to 3, **characterized in that** it has the formula Bi_{0.36}Pb_{0.64}Sc_{0.36-x}MnₓTi_{0.64}O₃ with x between 0.02 and 0.03.

5. A procedure for obtaining the ceramic material according to any of claim 1 to 4, **characterized in that** it comprises the following steps:
a) preparation of a nanocrystalline powder of formula Bi_{0.36}Pb_{0.64}Sc_{0.36-x}MnₓTi_{0.64}O₃, by mechanosynthesis from a stoichiometric mixture of Bi₂O₃, Sc₂O₃, PbO, TiO₂ and Mn₂O₃
wherein x ranges from 0.02 to 0.05; and
b) hot pressing of the nanocrystalline powder obtained in step (a)
• at a temperature range of between 1000 ºC and 700 ºC for soaking times between 5 h and 30 min or
• a pressure range of between 30 MPa and 90 MPa for soaking times between 5 h and 30 min,

6. The procedure for obtaining the ceramic material according to claim 5, **characterized in that** step (a) is performed, in a high energy planetary mill, at 300 rpm, for times ranging between 15 h and 20 h.

7. The procedure for obtaining the ceramic material according to any of claims 5 or 6, **characterized in that** the hot pressing of step (b) is performed
• at a temperature range of between 900 ºC and 700 ºC for soaking times between 5 h and 30 min or
• a pressure range of between 60 MPa and 90 MPa for soaking times between 5 h and 30 min.

8. Use of the ceramic material according to any of claims 1 to 4, as part of an ultrasound generation device.

9. Use of the ceramic material according to any of claim 1 to 4, as part of an ultrasonic motor or an ultrasonic actuator.
